# EUROPEAN PATENT SPECIFICATION

(11) **EP 3 319 912 B1**
(45) Date of publication and mention of the grant of the patent: **15.01.2020**
(21) Application number: 16741763.3
(22) Date of filing: 08.07.2016
(51) Int. Cl.: C03B 40/00, C04B 35/52, C04B 41/50, C04B 41/51, C04B 41/52, C04B 41/89, C04B 41/00, C03B 11/06, C23C 14/06, C23C 14/08, C23C 16/06, C23C 16/32, C23C 16/40, C23C 16/455

(54) **COATED MOLDS FOR GLASS FORMING**
BESCHICHTETE GUSSFORMEN FÜR GLAS
MOULES REVÊTUS POUR FAÇONNAGE DE VERRE

(30) Priority: 10.07.2015 US 201562191018 P
(43) Date of publication of application: 16.05.2018
(73) Proprietor: Entegris, Inc., Billerica, MA 01821 (US)
(72) Inventor: SCOGGINS, Troy, Decatur, TX 76234 (US); SHEPPARD, Rex Gerald, Decatur, TX 76234 (US)
(74) Representative: Greaves Brewster LLP
(86) International application number: PCT/US2016/041554
(87) International publication number: WO 2017/011315

(56) References cited:
- DE-A1-102011 107 802
- GB-A- 2 187 178
- US-A- 5 993 970
- US-A1- 2013 140 428
- US-A1- 2014 224 958
- DATABASE WPI Week 200337 28 March 2003 (2003-03-28) Thomson Scientific, London, GB; AN 2003-385934 XP002761617, -& JP 2003 089533 A (SUMITOMO ELECTRIC IND LTD) 28 March 2003 (2003-03-28)
- DATABASE WPI Week 200273 26 June 2002 (2002-06-26) Thomson Scientific, London, GB; AN 2002-677281 XP002772335, -& JP 2002 179485 A (SHINWA KOGYO KK) 26 June 2002 (2002-06-26)
- DATABASE WPI Week 200019 15 February 2000 (2000-02-15) Thomson Scientific, London, GB; AN 2000-218180 XP002772336, -& JP 2000 044843 A (MITSUBISHI JUKOGYO KK) 15 February 2000 (2000-02-15)

## Description

### CROSS-REFERENCE TO RELATED APPLICATIONS

### BACKGROUND

### Field of the Disclosure

This disclosure relates to coatings for glass shaping molds and to glass shaping molds comprising such coatings, as well as a method of making such molds.

### Description of the Related Art

Graphite is used in glass manufacturing equipment for glass bending and other glass forming operations, since the glass does not stick to graphite and graphite is easy to machine. Despite such advantages, however, graphite is subject to oxidation at temperatures at which glass bending or other forming operations are conducted. Oxidation creates pits in the graphite that in turn produce dimples or other surface asperities on the glass when it is bent or otherwise formed. Likewise, even though graphite is readily machinable, the machining operation, particularly when large grain size graphite is employed, can result in pits in the graphite surface that in turn cause dimples and other surface asperities on the processed glass surface.

A stainless steel mold for glass forming operations, which is coated with aluminum/titanium alloy or corresponding alloy oxide to provide a non-stick surface on a non-oxidizable substrate, is disclosed in U.S. Patent Application Publication 2014/0224958A1. This mold, however, requires multiple layers, including for example a metal diffusion barrier layer, in order to protect the molten glass from the underlying metal mold. In addition, metal molds require extensive machining and surface finishing, and are expensive to manufacture.

Glass handling drop guides, sometimes referred to as drop chutes, that are formed of graphite coated with titanium carbide/titanium/titanium oxide coatings have been used in glass manufacturing operations, but there is no requirement that such structures be fully encapsulated by the coating to prevent or reduce oxidation of the underlying graphite. This is attributable to the fact that such guides have very short contact time with molten or heated glass, e.g., on the order of 0.1 second, and the guides correspondingly are not required to embody the features of glass molds that are utilized to precision mold three-dimensional glass articles. In this respect, the surface finish of the glass handling drop guide and coatings thereon are not suitable for precision glass molding, e.g., as required for consumer electronic device applications, medical instruments, optical devices, etc.

US2013140428 A1 discloses a graphite glass mold coated with several layers including titanium and carbon in form of a carbide of another metal. The method for making the mold includes vapor deposition.

In other applications, graphite guide rings for use in glass bottle manufacturing have been coated with titanium carbide, but in such use there is no requirement that the graphite be encapsulated with a titanium carbide coating to reduce or prevent oxidation of the graphite body of such guide rings.

### SUMMARY

The present disclosure relates to precision glass molds comprising coatings according to claim 1, as well as to a method of making such molds according to claim 5.

In one aspect, the disclosure relates to precision glass molds comprising a fine grained graphite mold body having one or more mold features and an encapsulating coating atop the graphite mold body and the one or more mold features.

Another aspect of the disclosure relates to precision glass molds comprising a fine grained graphite mold body having one or more mold features and an encapsulating coating atop the graphite mold body and the one or more mold features. The encapsulating coating can comprise vapor deposited metal, and has a coefficient of thermal expansion that differs from the coefficient of thermal expansion of the graphite mold body by no more than one part per million/°C.

According to the disclosure the coating comprises a titanium carbide layer or region atop the graphite mold body. In still other embodiments the precision glass mold has a glass contacting layer or region that comprises titanium and oxygen, or a glass contacting layer or region that comprises titanium, oxygen, and carbon. The precision glass mold in various embodiments is free of surface discontinuities, e.g., dimples, cavities, protrusions, and other surface asperities, that are greater than about 25 microns from the average surface plane of the encapsulated mold, and preferably any deviations from such average surface plane are less than 25 microns, more preferably less than 20 microns, and most preferably less than 10 microns.

Another aspect of the disclosure relates to methods of making precision glass molds that include or comprise the acts or steps of forming an encapsulating coating comprising a titanium carbide layer or region atop a fine grain graphite mold body having one or more mold features. The encapsulating coating has a coefficient of thermal expansion that differs from the coefficient of thermal expansion of the graphite mold body by no more than one part per million/°C. The encapsulating coating includes stoichiometric or non-stoichiometric titanium carbide.

In some embodiments of the method of making a precision glass mold, a layer or region comprising titanium is formed atop the encapsulating coating. In such embodiments, the region comprising titanium can comprise an oxide of titanium. In still other embodiments of making the precision glass mold, there is a glass contacting layer or region of the precision glass mold that comprises titanium and oxygen, or a glass contacting layer or region that comprises titanium, oxygen, and carbon.

The method of making a precision glass mold in accordance with the present disclosure provides a precision glass mold that is free of surface discontinuities that are greater than about 25 microns from an average surface plane of the precision glass mold, and preferably any deviations from such average surface plane are less than 25 microns, more preferably less than 20 microns, and most preferably less than 10 microns in magnitude.

In a further embodiment, the disclosure relates to a glass mold comprising a fine grain graphite body and a coating thereon, further comprising titanium and yttria.

In another aspect, the disclosure relates to a method of making a glass mold of the present disclosure according to claim 5 including a titanium and yttria coating, in which the method comprises depositing the titanium and yttria coating, or one or more components thereof, over the fine-grained graphite body by a vapor deposition process.

The disclosure relates to another aspect to a glass mold according to claim 1 comprising a fine-grained graphite body having yttria coated thereon.

Other aspects, features and advantages of the disclosure will be more fully apparent from the ensuing description and appended claims.

### BRIEF DESCRIPTION OF THE DRAWINGS

FIG. 1 is a schematic illustration of a glass mold structure according to one embodiment of the disclosure.
FIG. 2 is schematic illustration of a glass mold structure according to another embodiment of the disclosure.
FIG. 3 is a set of photographs of yttria coated graphite coupons not according to the invention, at 1 µm average grain size (upper photograph) and 5 µm average grain size (lower photograph), compare a sample with no heat treatment (sample on left in each photograph) and a sample with 60 minutes of heat treatment (sample on right in each photograph).
FIG. 4 is a photograph of 2 inch square samples of titanium coatings on graphite coupons not according to the invention, in which three samples were heat-treated to 800°C, 850°C, and 900°C, respectively, for one hour, and a fourth sample was a TiC sample with no heat treatment.
FIG. 5 is a photograph of 2 inch square samples of titanium and yttria coatings (comprising a titanium carbide layer formed on the graphite body of the coupon, and yttria coated on the titanium carbide) on graphite coupons, in which three samples were heat-treated to 800°C, 850°C, and 900°C, respectively, for one hour, and the fourth sample was a TiC/yttria sample with no heat treatment.
FIG. 6 is an SEM image of a cross-section of a graphite sample coated with TiC and further coated with 0.5 µm of yttria.

### DETAILED DESCRIPTION

The present disclosure relates to precision glass molds made from coated graphite mold bodies, and to a method of making the coated graphite mold bodies as defined in the claims.

Unless defined otherwise, all technical and scientific terms used herein have the same meanings as commonly understood by one of ordinary skill in the art. Methods and materials similar or equivalent to those described herein can be used in the practice or testing of embodiments of the present disclosure.

As used herein, the terms "optional" or "optionally" means that the subsequently described event or circumstance may or may not occur, and that the description includes instances where the event occurs and instances where it does not.

While compositions and methods are described in terms of "comprising" various components or steps (interpreted as meaning "including, but not limited to"), the compositions and methods can also "consist essentially of" or "consist of" the various components and steps, and such terminology should be interpreted as defining essentially closed or closed member groups.

Although the disclosure is shown and described herein with respect to one or more particular implementations, equivalent alterations and modifications will occur to others skilled in the art based upon a reading and understanding of this specification and the annexed drawings. The invention includes all such modifications and alterations and is limited only by the scope of the following claims.

To the extent that the terms "includes", "having", "has", "with", or variants thereof are used herein in either the detailed description or the claims, such terms are intended to be inclusive in a manner similar to the term "comprising."

As used herein, the term "exemplary" is merely meant to mean an example, rather than the best.

It is to be appreciated that features, layers and/or elements depicted herein are illustrated with particular dimensions and/or orientations relative to one another for purposes of simplicity and ease of understanding, and that the actual dimensions and/or orientations may differ substantially from that illustrated herein.

The term "region" as used herein can refer to encapsulating coatings that may not have a distinct layer structure and wherein the composition of the coating may vary across the thickness of the coating and/or include non-stoichiometric compositions. For example, where a metal like titanium is vapor deposited on graphite, the deposited titanium material in the region closest to the graphite may be carbon rich and metal deficient. As vapor deposition of the metal continues a region that may be near stoichiometric titanium carbide can be formed according to the invention. As vapor deposition continues further still, a region that may be titanium metal can be formed. The term "layer" as used herein may be employed to refer to encapsulating coatings that have a more distinct "layer" structure and composition as opposed to those characterized as being a "region". "Layer" and "region" can be used to describe the structure of different embodiments of encapsulating coatings atop the graphite mold body.

As used herein, a graphite mold body having one or more mold features refers to any shaped mold made of fine grained graphite that can be used to repeatedly form a three dimensional article from molten glass that is pressed into the mold. The "mold feature" can be a cavity, a cavity including protrusions, combinations of these, or other features used to form shaped glass articles.

As used herein, the term "fine grain graphite" means graphite stock or ingot comprising graphite particles (grains) with sizes that do not exceed 10 microns. In some embodiments the graphite particle sizes (grain sizes) of the graphite comprising the mold may be on the order of 1 micron in size. In other embodiments, the graphite particle (grain) sizes comprising the mold may be on the order of 5 microns in size, and in still other embodiments, the graphite particle (grain) sizes of the graphite particles (grains) comprising the mold may be on the order of 10 microns. It will be recognized that in various embodiments, the grain size of the graphite may comprise a grain size distribution, e.g., in a range of from 1 to 10 microns, or a range of from 2 to 10 microns, 2 to 8 microns, 1.5 to 6.5 microns, or other suitable range, although it is preferred in practice to utilize graphite stock or ingot having a uniform or substantially uniform grain size, so that the CTE and other performance characteristics of the graphite body of the mold are as isotropic and homogeneous as possible. The graphite particle size for a mold or stock piece can be prepared by sieving graphite particles using standard sieves to achieve the desired particle size. A non-limiting example of a graphite with a fine grain size of about 10 microns or less and a CTE comparable to titanium is commercially available from Poco Graphite, Decatur, TX, USA under the trademark Glassmate-LT®.

The present disclosure relates to precision glass molds for shaping molten glass into articles. The glass mold is made of a graphite body with one or more mold features and a coating encapsulating the graphite mold body and the one or more mold features.

The coating in various embodiments has a coefficient of thermal expansion that differs from the coefficient of thermal expansion (CTE) of the graphite forming the mold body by an amount that does not exceed one part per million/°C of CTE of the graphite, wherein both the CTE of the coating and the CTE of the graphite forming the mold body are measured by the same technique in the same units. Such CTE differential of one part per million/°C or less ensures that the coating will not be susceptible to differential thermal expansion and contraction effects that would otherwise render the coating susceptible to delamination from the graphite forming the mold body, at a larger CTE differential between the coating and the graphite forming the mold body.

The coating atop the graphite comprises a titanium carbide region or layer. In still other embodiments the coating atop the graphite mold body and the one or more mold features comprises a titanium carbide region or layer and optionally a titanium metal region or layer overtop of the region containing titanium and carbon.

The glass molds of the present disclosure can be used for precision molding of glass articles that are free of wrinkles, dimples, cavities, protrusions, and other surface discontinuities and asperities. The articles formed by the glass mold in embodiments described herein can be used in consumer electronic devices, medical instruments, optical devices, and other applications requiring precision-molded glass articles.

In various embodiments, the glass mold has a titanium carbide layer, a titanium layer, and a titanium oxide layer on a graphite substrate, wherein the CTE of these materials is comparable to titanium and the underlying graphite. The titanium carbide, titanium, and titanium oxide layers of the coating encapsulate the graphite mold and features, thereby reducing or eliminating any oxidation of the glass mold surface. This allows a glass mold to be made from inexpensively machined graphite, but having the benefit of a hard, non-stick coating. Conventional graphite cannot be used for the glass mold surface because the CTE is too small and a titanium coating cracks and peels off when the coated mold is cooled.

Accordingly, it is critical that the coating on the graphite mold body have a close match of CTE values with the graphite mold body so that the coating retains good adhesion characteristics to the graphite mold body in use, since the mold will be subject to thermal swings when the molding surface(s) of the mold contact the molten or otherwise soft formable glass and when the mold is subsequently relieved of the formed glass article and the mold surfaces are exposed to the ambient environment before receiving a next-succeeding charge of formable glass at elevated temperature.

The surface finish or smoothness of a mold surface of a mold of the present disclosure can be measured mechanically with commercially available profilometers or laser devices. The mold surface can also be indirectly evaluated by examining light-scattering characteristics of surfaces of pressed glass elements produced by the mold.

An encapsulated mold surface having a surface roughness (e.g., pit or dimple) not exceeding about 25 microns deviation from the average surface plane of the mold can be a precision glass mold in various embodiments of the disclosure. In other embodiments, an encapsulated mold surface having a surface roughness (e.g., a pit or dimple) not exceeding about 15 microns deviation from the average surface plane can be a precision glass mold.

For precision molding, the mold surface finish is sufficiently smooth that the molten glass does not stick to the mold surface during processing, and this characteristic results in a molded glass article that can used to make the cover glass for various consumer electronic devices such as cellular phones, medical instruments, optical devices, etc.

In various embodiments, precision molded glass articles are free of wrinkles, dimples, or other surface discontinuities and surface asperities that are greater than about 25 microns in dimensional deviation from the average surface plane of the article. In other embodiments, precision molded glass articles are free of wrinkles, dimples, or other surface discontinuities and surface asperities that are greater than about 15 microns in dimensional deviation from the average surface plane of the article. It will be appreciated that the surface of the mold may be characterized in other manners, e.g., with reference to root mean square roughness or other parameterizing characteristics, to specify the product mold article of the present disclosure as having desirably smooth molding surface(s).

The coating encapsulates the graphite mold body and the one or more mold features. The encapsulating coating prevents oxidation or substantially reduces the oxidation of the underlying graphite mold body during glass molding, as compared to an uncoated graphite mold. The coating provides a release, or non-stick, surface and molten glass does not stick to the mold, thereby avoiding the creation of defects in the molded glass articles produced by the mold during glass molding and release operations, such as otherwise would otherwise occur if the formed glass were prone to stick to the molding surface of the coated mold article.

As indicated, the coating atop the graphite has a coefficient of thermal expansion that differs from the coefficient of thermal expansion of the graphite body by an amount of 1 part per million/°C or less, based on the graphite CTE, wherein both CTE values, of the coating and of the graphite, are measured by the same techniques and measured in the same units of measurement.

The coating on the graphite mold surfaces can be formed from titanium metal that is deposited on top of the graphite mold surfaces and features. The metal can be deposited by physical, chemical, or physicochemical methods, including, without limitation, physical vapor deposition (PVD), chemical vapor deposition (CVD), evaporation of metal source material, or any other suitable techniques or processes. The metal forms an encapsulating layer or region atop the graphite that is a composition that contains or includes the metal and carbon.

The encapsulating layer or region atop the graphite mold surfaces includes titanium metal carbide, which can be stoichiometric or non-stoichiometric in composition. Continued deposition of the metal can form a layer or region of metal atop the metal carbide or a metal layer or region atop the composition that includes metal and carbon. For example, in the case of vapor-deposited titanium metal, the encapsulating coating on the graphite mold surfaces forms a layer or region of titanium carbide atop the graphite and then a layer or region of titanium atop the titanium carbide. The surface of the titanium that is exposed to air forms a layer or region containing oxides of titanium and in some embodiments a layer or region containing titanium, oxygen and carbon.

In some embodiments the thickness of the coating is chosen to reduce oxidation of the underlying graphite. In various embodiments, the thickness of the coating can be greater than or equal to 10 nanometers and less than or equal to 500,000 nanometers, i.e., 10nm < t < 500,000 nm, where t is the coating thickness, in nanometers. Any other coating thicknesses can be employed, as suitable to encapsulate the graphite body, or selected part(s) thereof, and to prevent oxidation of the carbon body.

The coating deposited on top of the graphite in various embodiments is free of electroless or electroplated metal coatings directly atop the graphite, i.e., in direct contact with the graphite surface.

The carbon of the graphite body can be purified to reduce contaminants and form a high purity graphite body, as disclosed in U.S. Pat. No. 3,848,739, where a graphite mold body or graphite stock body is placed within a purification furnace in which it is contacted by a halogen-containing gas for a period of time and at a temperature sufficient to permit penetration of the halogen into the graphite body, to cause the halogen to react with and volatilize the inorganic impurities, and to expel such impurities from the graphite.

Advantageously, the titanium carbide coated graphite glass molds described herein allow for glass molds to be machined at relatively low cost, as compared to stainless steel or titanium molds, while providing a mold that resists oxidation at the mold surface. Using a graphite mold coated as described herein allows the graphite-based mold to be used during the entire service life of a mobile device or other molded glass containing article, thereby reducing the overall costs to manufacture shaped glass.

In another aspect, the disclosure relates to a glass mold comprising a fine grain graphite body and a coating thereon comprising titanium carbide and yttria. The graphite body comprises mold feature(s) including forming surface on which the titanium and yttria coating is coated so that the resultant coated forming surface is configured for shaping glass in contact therewith during glass molding operation. The graphite body is at least partially encapsulated with the titanium and yttria coating, including the forming surface of the graphite body, and preferably is the graphite body is fully encapsulated by the titanium and yttria coating.

The titanium carbide and yttria coating may be constituted in any compositional form providing enhancement of oxidation resistance of the fine grain graphite body. In various embodiments, the coating includes titanium on the graphite body, and such titanium is in a form of titanium carbide on the graphite body, e.g., at the interface of the graphite body and the coating, or otherwise in contact with the graphite body, and with an outer region of the coating including yttria. In various embodiments, the coating intermediate the titanium carbide and the yttria may include titanium in a form of titanium metal. In various embodiments, the coating intermediate the titanium carbide and the yttria may include titanium oxide. In any of such embodiments, the titanium carbide, yttria, and when present, titanium oxide, may independently be of stoichiometric or non-stoichiometric character.

Accordingly, the titanium carbide and yttria coating in specific implementations may include titanium carbide on the graphite body, on which in turn is a layer or region of titanium metal, on which in turn is a layer or region of yttria. In other implementations, the titanium and yttria coating may include titanium carbide on the graphite body, on which in turn is a layer or region of titanium metal, on which in turn is a layer or region of titanium oxide, on which in turn is a layer or region of yttria. In still other implementations, the titanium and yttria coating may include titanium carbide on the graphite body, on which in turn is a layer or region of titanium oxide, on which in turn is a layer or region of yttria.

It will therefore be appreciated that the titanium carbide and yttria coating may be constituted in any of a variety of compositional forms, as comprising an inner layer or region of titanium carbide on the graphite body, and an outer layer or region of yttria.

The titanium carbide and yttria coating thus in various embodiments may include an inner layer of titanium carbide, an intermediate layer including titanium metal, titanium oxide, or both titanium metal and titanium oxide, and an outer layer including yttria. The titanium carbide and yttria coating may also contain other coating components and/or layers, as may be necessary or desirable in specific applications of the glass mold article.

The respective components of the titanium carbide and yttria coating may be incorporated in the coating by any suitable coating formation techniques, by which the coating of desired character and composition may be achieved.

For example, titanium carbide may be deposited on the graphite body by any of various suitable vapor deposition techniques or processes, e.g., chemical vapor deposition (CVD), pulsed CVD, plasma-assisted CVD, physical vapor deposition (PVD), atomic layer deposition (ALD), sputtering, evaporative deposition, etc., using appropriate titanium source material, as for example an organotitanium source reagent such as titanium tetraisopropoxide (TTIP), Ti[OCH(CH₃)₂]₄ for CVD.

The titanium may be deposited on the graphite body in any suitable ambient deposition environment. The titanium will interact with the graphite body to form titanium carbide at the surface of the graphite body. Such deposition of titanium may be continued to form titanium metal over the titanium carbide or to form titanium oxide over the titanium carbide if the titanium metal is exposed to oxygen, or to form titanium metal over the titanium carbide and titanium oxide over the titanium metal, or to form titanium oxide over the titanium carbide, and any of these various deposition schemes may be carried out in continuous or otherwise consecutive deposition operations to constitute the respective regions or layers of the coating.

Subsequently, the titanium carbide based coating of a type as described above may be overcoated with yttria to complete the titanium and yttria coating on the graphite body. Such overcoating with yttria may be effected in any suitable manner. For example, yttrium may be deposited by any of the previously described vapor deposition techniques or processes, as conducted in an oxygen-containing ambient environment, or otherwise with deposited yttrium being exposed to oxygen to form yttria as an outermost layer or region of the titanium and yttria coating.

Although the foregoing discussion has been directed to techniques and processes for forming the titanium and yttria coating in consecutive regions and layers including an innermost region or layer of titanium carbide and then outermost region or layer of yttria, as successive discrete regions or layers, it will be appreciated that the coating may be constituted in a variety of other forms. For example, it may be desirable in some embodiments to dope the titanium carbide inner layer of the coating with yttrium, or additional titanium, or with other coating components. As another example, it may be desirable in other embodiments to utilize interlayers between consecutive layers of the coating to enhance coating performance properties such as tribological properties, delamination resistance, or other properties. For example, it may be desirable in some embodiments to utilize a pyrolyzed carbon layer or region in or under the titanium and yttria coating.

In the titanium carbide and yttria coating, the overall thickness of the coating may be of any suitable value that is effective to reduce oxidation of the underlying graphite body, and the titanium carbide and yttria coating may for example in specific embodiments have a total thickness that is in a range of from 10 nm up to 500,000 nm or more. In other embodiments, the total film thickness may be in a range of from 5 to 15 mils (127 to 381 microns), or in a range of from 6 to 10 mils (152.4 to 254 microns), or in a range of from 6 to 8 mils (152.4 to 203.2 microns), or other suitable range. Yttria likewise may be present in the coating at any suitable thickness, e.g., a thickness of from 0.1 to 100 microns, a thickness of from 0.2 to 10 microns, a thickness of from 0.25 to 2 microns, a thickness of from 0.5 to 1 micron, or other appropriate thickness for the specific application.

The fine-grained graphite body utilized in making the glass molds of the present disclosure advantageously have a coefficient of thermal expansion (CTE) that is in a range of from 7 to 9 parts per million/°C, and difference between the respective CTE values of the coating and the graphite body must not exceed one part per million/°C, and preferably is less than one part per million (ppm)/°C, more preferably is less than 0.75 ppm/°C, and most preferably is less than 0.5 ppm/°C.

It is to be appreciated that the disclosure herein in respect of glass molds including fine-grained graphite bodies coated with titanium carbide coatings is likewise applicable, to the extent compatible, to glass molds including fine-grained graphite bodies coated with titanium carbide and yttria coatings, and that disclosure herein in respect of glass molds including fine-grained graphite bodies coated with titanium carbide and yttria coatings is likewise applicable, to the extent compatible, to glass molds including fine-grained graphite bodies coated with titanium carbide coatings without yttria therein.

Accordingly, the coatings and the glass molds of the present disclosure achieve a substantial advance in the art, in providing glass molds with high oxidation resistance in which titanium carbide coating, yttria coating, or titanium carbide and yttria coating provides a smooth non-porous surface that improves the appearance of the form glass and requires less polishing of the glass after forming, in relation to graphite molds without a coating of the present disclosure.

The provision of titanium carbide and yttria coating on the graphite body is particularly advantageous in molding alumino-silicate glasses, wherein yttria inhibits the oxidation of titanium carbide under the conditions required for molding such alumino-silicate glasses, so that the titanium and yttria coating provides a non-porous, non-stick and oxidation-resistant forming surface of the glass mold, in which the yttria forms a bond with the titanium-based material that increases the adhesion of the yttria.

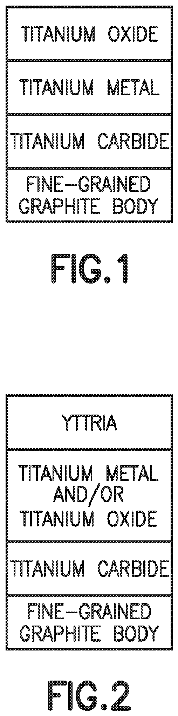

Referring now to the drawings, FIG. 1 is a schematic illustration of a glass mold structure according to one embodiment of the disclosure. As shown, the glass mold structure includes a fine-grained graphite body, on which is formed a layer of titanium carbide in direct contact with the graphite body, and over which is an intermediate layer of the titanium metal, over which is an outer layer of titanium oxide.

FIG. 2 is a schematic illustration of a glass mold structure according to another embodiment of the disclosure, in which the glass mold structure includes a fine-grained graphite body, on which is formed a layer of titanium carbide in direct contact with the graphite body, and over which is an intermediate layer that may comprise titanium metal and/or titanium oxide, over which is an outer layer of yttria. In the structure, the intermediate layer may comprise titanium metal alone, or alternatively the intermediate layer may comprise titanium oxide alone, or alternatively the intermediate layer may comprise a sublayer of titanium metal in direct contact with the titanium carbide and a sublayer of titanium oxide over and in direct contact with the sublayer of titanium metal, or alternatively the intermediate layer may comprise a heterogeneous combination of titanium metal and titanium oxide.

It will be appreciated that although the layer structures in FIGS. 1 and 2 have been shown as discrete consecutive layers, in the schematic depictions of the corresponding structures, the respective coatings may include layers or sub layers having compositional gradations at their respective interfaces between adjacent layers or sublayers.

The features and advantages of the coatings and glass molds of the present disclosure are further illustrated by the following non-limiting examples.

### EXAMPLE 1

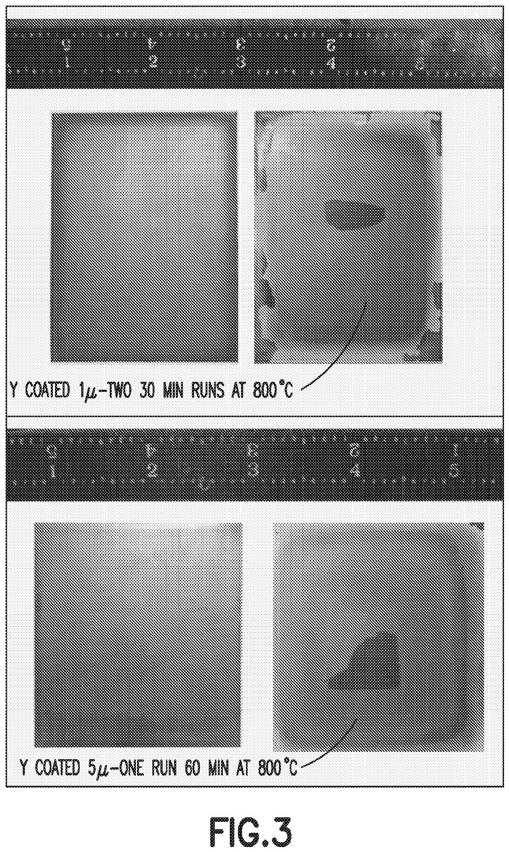

One and five micron average grain size graphite coupons 0.25 inch (0.635 cm) thick and 2 inches x 2 inches (5.08 cm x 5.08 cm) in size were pyro-sealed (sealed with a pyrolyzed carbon coating) and coated with 400-500 nm thickness of not according to the invention. The one micron average grain size samples were subjected to two 30 minutes runs at 800°C and the five micron average grain size samples underwent one 60 minute cycle at 800°C. Weights were taken before and after each heat treatment and given below in Table 1. Weight loss after 60 minutes was the same for the 1 and 5 micron samples. The bottom sample in each case had less weight loss than the top sample since it had less exposure. Both samples showed delamination of the yttria coating. The one micron sample was more severe, likely due to the extra thermal cycle. Molding of potassium ion-exchange aluminosilicate glass, of a type commercially available under the trademark GORILLA GLASS (Corning Incorporated, Corning, New York, USA), was simulated with the samples. Glass sample pickup of some of the yttria coating was observed in each of the first cycles, and no transfer was observed on the second 30 minute run. The photographs of FIG. 3 compare a sample with no heat treatment and a sample with 60 minutes of heat treatment.

**Table 1**

| | 1 micron base | |
|---|---|---|
| | 2-Bot | 3-Top |
| Initial | 36.628 | 36.188 |
| 30 @800° | 36.619 | 36.170 |
| % loss | 0.025 | 0.036 |
| 30 @800° | 36.610 | 36.156 |
| T % loss | 0.049 | 0.075 |

| | 5 micron base | |
|---|---|---|
| | 7-Bot | 8-Top |
| Initial | 29.372 | 29.360 |
| 60 @800° | 29.357 | 29.337 |
| % loss | 0.051 | 0.078 |

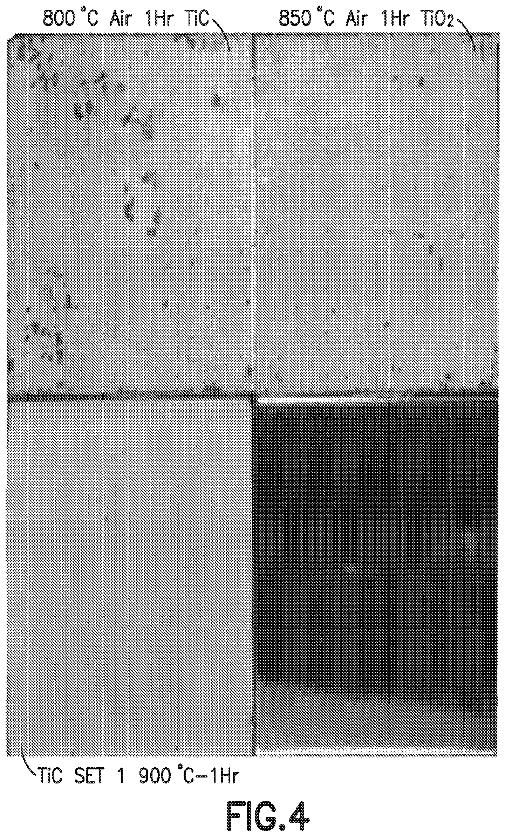

FIG. 4 is a photograph of 2 inch square (5.08 cm x 5.08 cm) samples of titanium coatings not according to the invention on 0.25 inch (0.635 cm) thickness graphite coupons. Three samples were heat-treated to 800°C, 850°C, and 900°C, respectively, for one hour. The fourth sample is a TiC sample with no heat treatment. The non-heat-treated sample exhibited a reflective silver appearance, while the 3 heat-treated samples were white in color, indicative of titanium dioxide having been formed.

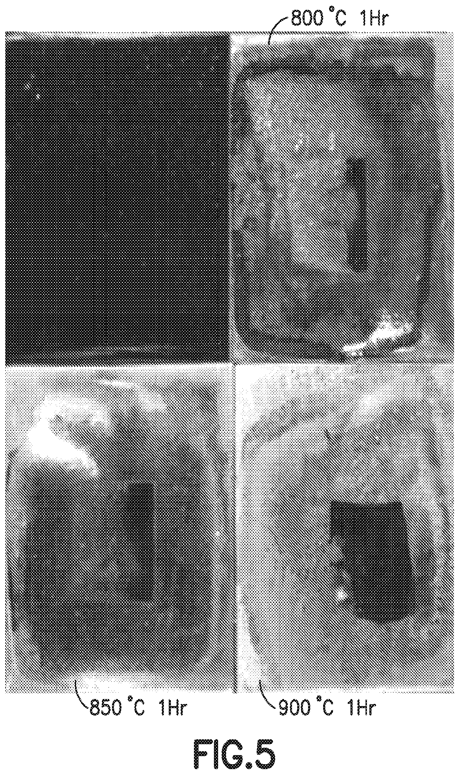

FIG. 5 is a photograph of 2 inch square (5.08 cm x 5.08 cm) samples of titanium and yttria coatings (comprising a titanium carbide layer formed on the graphite body of the coupon, and yttria coated on the titanium carbide) on graphite coupons of 0.25 inch (0.635 cm) thickness. Three samples were heat-treated to 800°C, 850°C, and 900°C, respectively, for one hour. The fourth sample is a TiC/yttria sample with no heat treatment. The non-heat-treated sample exhibited a reflective deep purple appearance, while the three heat-treated samples had a reflective silver appearance. The "partial dark squares" in the heat-treated samples were an artifact of the glass samples that were molded during the heat treatment. No delamination of the titanium and yttria coatings was seen, and the titanium and yttria coatings were observed to fully retain the structural integrity and properties of the corresponding initially formed titanium and yttria coatings.

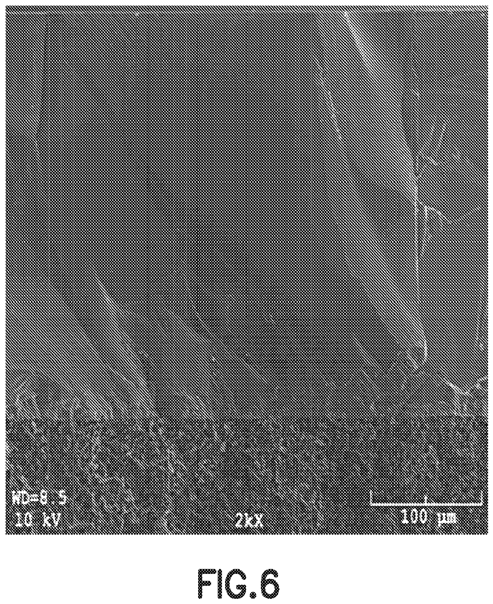

FIG. 6 is an SEM image of a cross-section of a graphite sample coated with TiC and further coated with 0.5 µm of yttria.

Accordingly, while the disclosure has been has been set out herein in reference to specific aspects, features and illustrative embodiments, it will be appreciated that the utility of the disclosure is not thus limited, but rather extends to and encompasses numerous other variations, modifications and alternative embodiments, as will suggest themselves to those of ordinary skill in the field of the present disclosure, based on the description herein. Correspondingly, the invention as hereinafter claimed is intended to be broadly construed and interpreted, as including all such variations, modifications and alternative embodiments, all within the scope of the claims.

## Claims

1. A precision glass mold comprising:
a fine grained graphite mold body having one or more mold features;
an encapsulating coating atop the graphite mold body and the one or more mold features, wherein the encapsulating coating comprises a titanium carbide layer or region atop the graphite mold body and has a coefficient of thermal expansion that is within 1 part per million/°C of the coefficient of thermal expansion of the graphite mold body.

2. The precision glass mold of claim 1 where the graphite grain size is 10 microns or less than 10 microns.

3. The precision glass mold according to any preceding claim, wherein the encapsulating coating comprises a titanium metal or a titanium oxide layer or region atop the titanium carbide layer or region.

4. The precision glass mold according to any preceding claim, that is free of surface discontinuities that are greater than about 25 microns from the average surface plane of the article.

5. A method of making a precision glass mold comprising:
forming an encapsulating coating comprising a titanium carbide layer or region atop a fine grain graphite mold body having one or more mold features, the encapsulating coating having a coefficient of thermal expansion that is within 1 part per million/°C of the coefficient of thermal expansion of the graphite mold body.

6. A precision glass mold according to any of claims 1 to 4, wherein the encapsulating coating comprises an outer layer or region of yttria.

7. The precision glass mold of claim 6, wherein the one or more mold features include forming surface on which the encapsulating coating is coated so that the resultant coated forming surface is configured for shaping glass in contact therewith during glass molding operation.

8. The precision glass mold according to any of claims 6 or 7, wherein the graphite body is at least partially encapsulated with the encapsulating coating, including a forming surface of the graphite body.

9. The precision glass mold according to any of claims 1,2 and 4, wherein the encapsulating coating includes the titanium carbide layer or region on the graphite body, on which in turn is a layer or region of titanium metal, on which in turn is a layer or region of yttria.

10. The precision glass mold according to any of claims 1,2 and 4, wherein the encapsulating coating includes the titanium carbide layer or region on the graphite body, on which in turn is a layer or region of titanium metal, on which in turn is a layer or region of titanium oxide, on which in turn is a layer or region of yttria.

11. The precision glass mold according to any of claims 1,2 and 4, wherein the encapsulating coating includes the titanium carbide layer or region on the graphite body, on which in turn is a layer or region of titanium oxide, on which in turn is a layer or region of yttria.

12. The precision glass mold according to any of claims 1,2 and 4, wherein the encapsulating coating includes the inner layer of titanium carbide, an intermediate layer including titanium metal, titanium oxide, or both titanium metal and titanium oxide, and an outer layer including yttria.

13. The precision glass mold according to any of any of claims 1 to 4 and 6 to 12, wherein the encapsulating coating comprises an outer layer or region of yttria and wherein the precision glass mold further comprises a pyrolyzed carbon layer or region in or under the encapsulating coating.

## Patentansprüche

1. Präzisionsglasform, umfassend:
einen feinkörnigen Graphitformkörper mit einem oder mehreren Formmerkmalen,
eine einkapselnde Beschichtung auf dem Graphitformkörper und dem einen oder den mehreren Formmerkmalen,
wobei die einkapselnde Beschichtung eine Schicht oder einen Bereich aus Titancarbid auf dem Graphitformkörper umfasst und einen thermischen Ausdehnungskoeffizienten aufweist, der innerhalb von 1 ppm/° C des thermischen Ausdehnungskoeffizienten des Graphitformkörpers liegt.

2. Präzisionsglasform nach Anspruch 1, worin die Graphit-Korngröße 10 µm oder weniger als 10 µm beträgt.

3. Präzisionsglasform nach einem der vorhergehenden Ansprüche, worin die einkapselnde Beschichtung eine Schicht oder einen Bereich aus Titanmetall oder Titanoxid auf der Schicht oder dem Bereich aus Titancarbid umfasst.

4. Präzisionsglasform nach einem der vorhergehenden Ansprüche, die frei ist von Oberflächenfehlstellen, die größer sind als etwa 25 µm von der durchschnittlichen Oberflächenebene des Gegenstands.

5. Verfahren zur Herstellung einer Präzisionsglasform, umfassend:
Bilden einer einkapselnden Beschichtung, die eine Schicht oder einen Bereich aus Titancarbid auf einem feinkörnigen Graphitformkörper mit einem oder mehreren Formmerkmalen umfasst, wobei die einkapselnde Beschichtung einen thermischen Ausdehnungskoeffizienten aufweist, der innerhalb von 1 ppm/° C des thermischen Ausdehnungskoeffizienten des Graphitformkörpers liegt.

6. Präzisionsglasform nach einem der Ansprüche 1 bis 4, worin die einkapselnde Beschichtung eine äußere Schicht oder einen äußeren Bereich aus Yttriumoxid umfasst.

7. Präzisionsglasform nach Anspruch 6, worin das eine oder die mehreren Formmerkmale eine Formoberfläche umfassen, auf die die einkapselnde Beschichtung beschichtet wird, sodass die resultierende beschichtete Formoberfläche zum Formen von Glas ausgebildet ist, das mit dieser während eines Glasformvorgangs in Kontakt ist.

8. Präzisionsglasform nach einem der Ansprüche 6 oder 7, worin der Graphitkörper zumindest teilweise mit der einkapselnden Beschichtung, einschließlich einer Formoberfläche des Graphitkörpers, eingekapselt ist.

9. Präzisionsglasform nach einem der Ansprüche 1, 2 und 4, worin die einkapselnde Beschichtung die Schicht oder den Bereich aus Titancarbid auf dem Graphitkörper umfasst, worauf sich wiederum eine Schicht oder ein Bereich aus Titanmetall befindet, worauf sich wiederum eine Schicht oder ein Bereich aus Yttriumoxid befindet.

10. Präzisionsglasform nach einem der 1, 2 und 4, worin die einkapselnde Beschichtung die Schicht oder den Bereich aus Titancarbid auf dem Graphitkörper umfasst, worauf sich wiederum eine Schicht oder ein Bereich aus Titanmetall befindet, worauf sich wiederum eine Schicht oder ein Bereich aus Titanoxid befindet, worauf sich wiederum eine Schicht oder ein Bereich aus Yttriumoxid befindet.

11. Präzisionsglasform nach einem der 1, 2 und 4, worin die einkapselnde Beschichtung die Schicht oder den Bereich aus Titancarbid auf dem Graphitkörper umfasst, worauf sich wiederum eine Schicht oder ein Bereich aus Titanoxid befindet, worauf sich wiederum eine Schicht oder ein Bereich aus Yttriumoxid befindet.

12. Präzisionsglasform nach einem der 1, 2 und 4, worin die einkapselnde Beschichtung die innere Schicht aus Titancarbid, eine Zwischenschicht, die Titanmetall, Titanoxid oder sowohl Titanmetall als auch Titanoxid umfasst, und eine äußere Schicht aufweist, die Yttriumoxid enthält.

13. Präzisionsglasform nach einem der 1 bis 4 und 6 bis 12, worin die einkapselnde Beschichtung eine äußere Schicht oder einen äußeren Bereich aus Yttriumoxid umfasst und worin die Präzisionsglasform weiter eine Schicht oder ein Bereich aus pyrolysiertem Kohlenstoff in oder unter der einkapselnden Beschichtung aufweist.

## Revendications

1. Moule pour verre de précision comprenant :
un corps de moule en graphite à grains fins présentant une ou plusieurs caractéristiques de moule ; un revêtement d'encapsulation placé au-dessus du corps de moule en graphite et la ou les caractéristiques de moule, ledit revêtement d'encapsulation comprenant une couche ou zone de carbure de titane au-dessus du corps de moule en graphite et possédant un coefficient de dilatation thermique se situant dans les limites de 1 partie par million/°C du coefficient de dilatation thermique du corps de moule en graphite.

2. Moule pour verre de précision selon la revendication 1, ladite taille des grains de graphite étant égale à 10 micromètres ou inférieure à 10 micromètres.

3. Moule pour verre de précision selon l'une quelconque des revendications précédentes, ledit revêtement d'encapsulation comprenant une couche ou zone de métal de titane ou d'oxyde de titane au-dessus de la couche ou zone de carbure de titane.

4. Moule pour verre de précision selon l'une quelconque des revendications précédentes, qui est exempt de discontinuités de surface supérieures à environ 25 micromètres par rapport au plan de surface moyen de l'article.

5. Procédé de fabrication d'un moule pour verre de précision comprenant :
la formation d'un revêtement d'encapsulation comprenant une couche ou zone de carbure de titane au-dessus du corps de moule en graphite à grains fins possédant une ou plusieurs caractéristiques de moule, le revêtement d'encapsulation possédant un coefficient de dilatation thermique qui est dans les limites de 1 partie par million/°C du coefficient de dilatation thermique du corps de moule en graphite.

6. Moule pour verre de précision selon l'une quelconque des revendications 1 à 4, ledit revêtement d'encapsulation comprenant une couche ou zone externes d'yttria.

7. Moule pour verre de précision selon la revendication 6,
ladite ou lesdites caractéristiques de moule comprenant une surface de formage sur laquelle le revêtement d'encapsulation est revêtu afin que la surface de formage revêtue résultante soit conçue pour façonner le verre en contact avec celle-ci durant l'opération de moulage du verre.

8. Moule pour verre de précision selon l'une quelconque des revendications 6 ou 7, ledit corps en graphite étant au moins partiellement encapsulé avec le revêtement d'encapsulation, comprenant une surface de formage du corps en graphite.

9. Moule pour verre de précision selon l'une quelconque des revendications 1, 2 et 4, ledit revêtement d'encapsulation comprenant la couche ou zone de carbure de titane sur le corps en graphite, sur laquelle, à son tour, se trouve une couche ou zone de métal de titane, sur laquelle, à son tour, se trouve une couche ou zone d'yttria.

10. Moule pour verre de précision selon l'une quelconque des revendications 1, 2 et 4, ledit revêtement d'encapsulation comprenant la couche ou zone de carbure de titane sur le corps en graphite, sur laquelle, à son tour, se trouve une couche ou zone de métal de titane, sur laquelle, à son tour, se trouve une couche ou zone d'oxyde de titane, sur laquelle, à son tour, se trouve une couche ou zone d'yttria.

11. Moule pour verre de précision selon l'une quelconque des revendications 1, 2 et 4, ledit revêtement d'encapsulation comprenant la couche ou zone de carbure de titane sur le corps en graphite, sur laquelle, à son tour, se trouve une couche ou zone d'oxyde de titane, sur laquelle, à son tour, se trouve une couche ou zone d'yttria.

12. Moule pour verre de précision selon l'une quelconque des revendications 1, 2 et 4, ledit revêtement d'encapsulation comprenant la couche interne de carbure de titane, une couche intermédiaire comprenant du métal de titane, de l'oxyde de titane ou du métal de titane et de l'oxyde de titane, et une couche externe comprenant de l'yttria.

13. Moule pour verre de précision selon l'une quelconque des revendications 1 à 4 et 6 à 12, ledit revêtement d'encapsulation comprenant une couche ou zone externes d'yttria et ledit moule pour verre de précision comprenant en outre une couche ou zone de carbone pyrolysé dans ou sous la couche d'encapsulation.
